Europäisches Patentamt

European Patent Office

Office européen des brevets

(19)

(11) Numéro de publication : **0 077 278**
**B1**

(12)

# FASCICULE DE BREVET EUROPÉEN

(45) Date de publication du fascicule du brevet :
**27.05.87**

(51) Int. Cl.⁴ : **G 03 F   7/10**

(21) Numéro de dépôt : **82420134.7**

(22) Date de dépôt : **28.09.82**

(54) Composition photosensible et plaque lithographique réalisée à l'aide de cette composition.

(30) Priorité : **02.10.81 FR 8118583**

(43) Date de publication de la demande :
**20.04.83 Bulletin 83/16**

(45) Mention de la délivrance du brevet :
**27.05.87 Bulletin 87/22**

(84) Etats contractants désignés :
**AT BE CH DE FR GB IT LI LU NL SE**

(56) Documents cités :
**EP-A- 0 030 213**
**FR-A- 2 196 488**
**GB-A- 1 148 362**
**US-A- 3 980 483**

(73) Titulaire : **RHONE-POULENC MULTI-TECHNIQUES**
**25 Quai Paul Doumer**
**F-92408 Courbevoie Cedex (FR)**

(72) Inventeur : **Hazan, Marta**
**72, quai Maréchal Joffre**
**F-92400 Courbevoie (FR)**
Inventeur : **Pigeon, Marcel**
**66, rue de Longchamp**
**F-92200 Neuilly-sur-Seine (FR)**

(74) Mandataire : **Varnière-Grange, Monique et al**
**RHONE-POULENC INTERSERVICES Service Brevets**
**Chimie Centre de Recherches de Saint-Fons B.P. 62**
**F-69192 Saint-Fons Cédex (FR)**

**0 077 278**

**Description**

La présente invention concerne une nouvelle composition photosensible destinée, en particulier, à la préparation de plaques lithographiques.

Les matériaux photosensibles, employés actuellement pour un tel usage, comprennent en général des résines solides servant de liant au système photosensible composé d'un monomère et d'un photosensibilisateur. Ils peuvent comprendre des résines époxy avec diverses fonctions. Ces résines qui constituent le liant de la couche photosensible, sont à l'état solide lors de l'utilisation de la plaque. Une réticulation en présence du photosensibilisateur et d'un monomère approprié, rend la couche insoluble dans son solvant aux endroits insolés sélectivement grâce à une source lumineuse et à l'interposition d'un cliché portant l'image à reproduire, sur le trajet de rayons actiniques, entre la source et la couche photosensible. La surface du revêtement non insolé reste soluble et est éliminée par lavage, à l'aide d'un solvant approprié, laissant apparaître une surface hydrophile alors que la couche de revêtement restante est encrophile. On peut ainsi reproduire l'image selon un procédé bien connu. La réticulation de ces résines solides exige une exposition aux radiations actiniques d'une durée généralement supérieure à la minute.

Ceci nécessite un matériel spécial avec une lampe de grande puissance et ne permettant que l'insolation par contact, et excluant donc la possibilité d'exposition par projection. On observera ainsi que le brevet européen 30 213 décrit une composition photosensible constituée par un photosensibilisateur et par une résine acrylique (ou méthacrylique), de telle manière que les groupements époxydes ne soient pas tous transformés et que l'indice d'acide soit inférieur à 0,2. Cette composition ne contient pas, contrairement à la notre, d'acrylates ou de polyacrylates de polyols ou d'oligomères hydroxylés. Cette composition exige pour être convenablement réticulée des durées d'insolation importantes avec des lampes très puissantes.

Dans le brevet américain 3 980 483 sont décrites des compositions photosensibles contenant outre un monomère éthylénique photosensible (acrylate ou polyacrylate), un photoinitiateur et une résine époxyde modifiée en deux temps.

On additionne d'abord à la résine époxyde de l'acide acrylique ou méthacrylique de telle manière que demeurent libres des groupements hydroxyles. Dans un deuxième temps on fait réagir la résine époxyacrylate porteuse de groupements hydroxyles avec un anhydride d'acide dicarboxylique (anhydride succinique...).

On voit donc que la résine époxyde modifiée selon le brevet américain 3 980 483 contient des groupements carboxyliques libres, ce qui explique la raison pour laquelle les parties non insolées de cette résine époxyde sont éliminées à l'aide de solutions alcalines aqueuses.

Il a maintenant été trouvé une composition photosensible ne nécessitant que des insolations de très courte durée.

La présente invention concerne donc une composition photosensible, destinée en particulier à la préparation de plaques lithographiques, comprenant une résine époxy-acrylate liquide ou visqueuse caractéristique, un monomère pris dans le groupe des acrylates et méthacrylates d'alcools polyhydroxylés ou d'oligomères polyhydroxylés et au moins, un photosensibilisateur.

La résine époxy-acrylate mise en œuvre peut être préparée elle-même par tout procédé connu. Outre la copolymérisation de monomère acrylique et/ou époxyde on peut modifier des résines époxydes notamment les résines époxydes liquides en les faisant réagir avec l'acide acrylique ou méthacrylique ou encore avec un polymère ou un copolymère acrylique préparé préalablement et possédant des groupements carboxyliques réactifs. De telles préparations sont par exemple décrites dans l'ouvrage de M.W. Ranney époxy resin and products recent advances [Noyes data corporation 1977].

La présente invention a pour objet des compositions photosensibles destinées en particulier à la préparation de plaques lithographiques et comprenant une résine époxy acrylate liquide ou visqueuse, un monomère pris dans le groupe formé par les acrylates ou méthacrylates de polyols ou d'oligomères hydroxylés et au moins un photoinitiateur caractérisé en ce que la résine époxide dont la viscosité à 60 °C est comprise entre 4 et 8 Pa.s et dont le poids moléculaire est compris entre 400 et 1 000 présente deux liaisons oléfinique terminales et appartient aux résines époxy-phénol-novolaques ou aux résines époxy contenant du bisphénol A ou F et où, au moins deux groupes époxydes par mole de résine finale sont en quasi-totalité ouverts et estérifiés, et en ce que la résine époxy acrylate et le monomère acrylique se trouvent dans un rapport pondéral compris entre 5 : 1 et 2 : 1.

Le poids moléculaire des résines époxy de l'invention est généralement compris entre 400 et 1 000 ; avantageusement inférieur à 800 et de préférence compris entre 400 et 600 ; elles présentent deux liaisons oléfiniques terminales et contiennent généralement du bisphénol A ou F. Au moins deux groupes époxides par mole de résine finale ont été mis en œuvre lors de leur préparation mais sont en quasi totalité ouverts et estérifiés. Parmi ces résines, on peut citer les produits vendus par « Shell Chemical Corp. » sous l'appellation « Epocryl 370 » ou par « Union Chimique Belge » sous l'appellation « Ebecryl 600 ».

Les résines époxy liquides utilisables sont elles-mêmes bien connues.

D'une façon générale, on en trouvera une description détaillée dans les pages 312 à 329 du premier

2

volume supplémentaire de « Encyplopedia of Chemical Technology » édité par Kirk and Othmer et publié par Interscience Encyclopedia Inc — New-York — 1975, ainsi qu'aux pages 340 à 528 du livre « Epoxyverbinduengen und Epoxy Harze » édité par Paquin et publié par Springer-Verlag — Berlin — Gottingen und Heidelberg — 1958. Les résines époxy convenant sont en particulier les éthers glycidiques du bisphénol A ainsi que les résines époxy novolaques phénol ou crésol. Parmi les éthers glycidiques du bisphénol A, on citera préférentiellement les éthers diglycidiques.

De telles résines fluides à température ambiante peuvent être utilisées seules ou en mélanges, de façon à ajuster éventuellement leur viscosité.

Pour plus de détails concernant les caractéristiques et mode de préparation de telles résines époxy fluides, on pourra se reporter avantageusement au brevet US-3 794 576.

A titre non limitatif, les résines époxy liquides couramment disponibles dans le commerce et qui conviennent dans le cadre de la présente invention sont :

dans les produits vendus par la Société Ciba Geigy sous la marque Araldite, les références GY 255, GY 260, ainsi que les références EPN 1138 et EPN 1139,

dans les produits vendus par la Société Shell, sous les marques Epikote ou Epon, les références 827, 828, 834, etc...

Le deuxième élément de la composition est un monomère pris dans le groupe formé par les acrylates ou méthacrylates de polyols ; il contient, de préférence, de 2 à 10 atomes de carbone par molécule et de 2 à 4, et plus préférentiellement, au moins trois radicaux acryliques par molécule. On peut citer notamment le triacrylate et le triméthacrylate de pentaérythritol, l'acrylate de bis pentaérythritol, le diméthacrylate de diéthylèneglycol, le diacrylate de 1-4 butanediol, le diacrylate de néopentylglycol, le diacrylate de tripropylèneglycol, le diacrylate de tétraéthylène-glycol, le triacrylate de triméthylol-propane et des triacrylates d'oligomères hydroxylés. Ces produits sont liquides à température ambiante.

Les photosensibilisateurs qui peuvent être mis en œuvre dans la composition de l'invention, sont les composés miscibles au mélange de résine et monomère, susceptibles d'initier la polymérisation radicalaire des monomères mentionnés ci-dessus sous l'effet d'une radiation de longueur d'onde supérieure à 320 nm. Ces produits sont bien connus par les spécialistes de la préparation de plaques lithographiques. On peut citer le benzyldiméthyl-acétal vendu notamment sous le nom « d'Irgacure 651 » par la Sté Ciba-Geigy, la benzoïne et ses éthers méthyliques, éthyliques, isopropyliques ou butyliques et la cétone de Michler. Deux ou plusieurs composés de chaque groupe de la composition peuvent être introduits dans celle-ci. En particulier, en ce qui concerne les photosensibilisateurs, la plage de sensibilité aux radiations, est élargie lorsqu'un mélange, par exemple « d'Irgacure G 51 » d'une part et de cétone de Michler ou d'éther éthylique de benzoïne d'autre part, est présent dans la composition.

Un quatrième groupe de produits utiles dans la composition de l'invention est constitué par les inhibiteurs de polymérisation thermique, c'est-à-dire les substances qui empêchent la polymérisation radicalaire de se produire sous l'effet d'un apport de calories, sans bloquer cependant la photopolyméri-sation. Ces produits sont également bien connus des spécialistes ; on peut citer les phénols et polyphénols, des éthers ou esters de phénols ou polyphénols, par exemple, les éthers méthylique, éthylique isopropylique et butylique de l'hydroquinone, le p-méthoxyphénol, le t- ou n-butylparacrésol.

Des colorants et différents autres additifs peuvent également être présents dans la composition.

Les produits à l'état liquide ou modérément visqueux, ou en suspension pour ceux présents en faible proportion, se mélangent facilement pour former une composition homogène. Ils sont mis en œuvre et sont donc présents dans la composition, dans les proportions ou rapports suivants. Le rapport pondéral de la résine sur le monomère est compris entre 5 : 1 et 1 : 1, la proportion pondérale de photosensibilisateur par rapport à la résine liquide est compris entre 15 et 35 %. La proportion pondérale d'inhibiteur par rapport à la résine est de 0,5 à 1,5 %.

Il est cependant possible d'obtenir certains résultats en opérant en dehors des limites indiquées ci-dessus, du rapport résine/monomère. On se heurte alors cependant, à diverses difficultés. Si ce rapport est trop faible, la couche reste trop poisseuse et est donc difficilement manipulable ; son stockage et son emballage sont difficiles. Si ce rapport est trop élevé, la couche présente une sensibilité plus faible, ce qui amoindrit son intérêt pratique. De même, si le pourcentage de photosensibilisateur est inférieur à 15 % par rapport à la résine, la sensibilité de la plaque est réduite. Il est par ailleurs inutile de dépasser la proportion de 30 % qui n'apporte aucun gain de sensibilité.

Un autre objet de l'invention est la plaque lithographique comprenant la composition de l'invention. Cette plaque est constituée d'un support généralement métallique, qui peut être de l'aluminium éventuellement anodisé ou de l'acier cuivré puis chromé, enduit sur une de ses faces. Un traitement bien connu, d'abrasion mécanique, chimique ou électrochimique a été appliqué à la plaque pour lui conférer un faible relief (aspect grainé). Elle est d'abord enduite de préférence, de silicate de soude, qui peut être du fluosilicate dans le cas de l'aluminium, ou de silice sous forme de sol notamment. Une couche de polymère hydrosoluble tel que le polyacrylamide est de préférence, appliquée ensuite.

Un autre objet de la présente invention est constitué par un procédé de préparation d'une plaque lithographique consistant à déposer sur une plaque métallique une couche photosensible d'épaisseur comprise entre 0,5 et 2 µm et constituée d'une composition photosensible diluée dans un solvant polaire relativement volatil, la composition étant elle-même constituée par une résine époxy acrylate liquide ou visqueuse, un monomère pris dans le groupe formé par les acrylates ou méthacrylates de polyols ou

**0 077 278**

d'oligomères hydroxyles et, par au moins un photosensibilisateur, puis à sécher la plaque. Les divers constituants de la composition sont évidemment ceux qui ont été précédemment décrits.

Le support ainsi revêtu de la composition de l'invention sur une épaisseur de 0,5 à 2 µm correspond à un dépôt ayant un poids de l'ordre du gramme par m². Pour ce faire, la composition est diluée dans un solvant polaire relativement volatil (Eb < 150 °C), ne réagissant pas avec les ingrédients de la composition. On peut citer comme solvant, le méthyl, éthyl, propyl- ou butyl-cellosolve, l'acétone, la méthyl-éthyl- ou méthyl-isopropyl-cétone, l'éthanol, l'isopropanol, le n-butanol, le dioxane, la diméthyl-formamide. Cette enduction est faite selon des techniques bien connues par exemple, sur une tournette ou par la technique dite « au rideau » dans lesquelles la dilution de la composition dans le solvant, est de l'ordre de 2 à 5 % en poids ou « au trempé » ; la dilution peut alors être plus faible, soit de l'ordre de 25 à 30 %.

La plaque est ensuite séchée à température modérée (de l'ordre de 60 à 80 °C) puis de préférence, enduite d'une couche de produit formant barrière vis-à-vis de l'oxygène, par exemple de l'alcool polyvinylique.

La plaque de l'invention ainsi réalisée comprend donc un support, notamment d'aluminium grainé, revêtu d'une mince couche de silice ou silicate de sodium ou de produits résultant de l'action de ces corps sur leurs substrats et éventuellement de polyacrylamide puis de la composition de l'invention et de préférence d'une couche barrière vis-à-vis de l'oxygène.

Etant donné la sensibilité à la lumière des plaques selon l'invention, celles-ci seront stockées et manipulées au moins dans la semi-obscurité, ou, de préférence, en lumière jaune inactinique.

L'insolation de la plaque se fait de façon traditionnelle, de préférence dans un châssis à vide, à l'aide d'un arc ou de préférence d'une lampe à vapeur de mercure dopée halogène. L'insolation peut ne durer que quelques secondes dans un matériel classique. Il est donc possible de réaliser des expositions par exposition ou tout autre moyen exigeant une rapidité plusieurs dizaines de fois plus élevée que les plaques négatives classiques.

Le développement ne nécessite pas l'utilisation de solvants organiques mais simplement d'une solution aqueuse alcaline diluée, notamment de métasilicate de sodium, additionnée de produit tensioactif. Le révélateur conventionnel des plaques positives est donc utilisable sur cette plaque qui peut être traitée dans un matériel de développement existant.

En dehors de la préparation de plaques lithographiques, la composition de l'invention est susceptible d'être utilisée dans différentes techniques de reproduction d'écritures, de dessins ou d'objets et de façon générale, dans les techniques où une insolubilisation sélective du revêtement d'une surface, sous l'effet d'une irradiation, est nécessaire.

Les exemples ci-dessous sont donnés aux seules fins d'illustration de l'invention et ne peuvent donc limiter la portée de la protection précisée dans les revendications.

### Exemple 1

On prépare une solution photosensible selon la formule suivante :

| | |
|---|---|
| — triacrylate de pentaerythritol | 1 g |
| — résine époxy acrylate « Ebecryl 600 » de la Société Union Chimique Belge (UCB) | 3 g |
| — méthylcellosolve | 150 g |
| — n-butanol | 20 g |
| — « Irgacure 651 » de la Société Ciba-Geigy | 0,60 g |
| — cétone de Michler | 0,3 g |
| — éther monométhylique de l'hydroquinone | 0,03 g |

On enduit cette solution, à l'aide d'une tournette à raison de 50 t/mm pendant 30 sec., sur une plaque d'aluminium grainée de la façon habituelle avec la ponce et traitée pendant 30 sec., avec une solution de fluosilicate de sodium à 7 g/l additionné de 10 g d'acide acétique.

On sèche la couche dans la tournette pendant 5 mn à 40 °C puis 5 minutes en étuve à 80 °C.

Le poids de couche déposé est de 1 g/m². On expose la plaque ainsi obtenue à travers un montage négatif sous une lampe à arc du type NU ARC 2 KW, distante de 60 cm pendant 5 secondes. On développe la plaque en éliminant des parties non insolées avec le révélateur « QM 805 » (commercialisé par la Société Rhône-Poulenc Systèmes), qui est une solution aqueuse de métasilicate de sodium et de mouillant. Cette opération est très rapide. On obtient une excellente copie, avec 7 à 8 plages couvertes de la gamme Stauffer.

Il est à noter que le temps nécessaire d'insolation pour des plaques analogues conventionnelles ayant une couche photosensible négative, est de l'ordre de 100 secondes.

### Exemple comparatif A

On prépare une solution photosensible selon l'exemple 1, en remplaçant la résine « Ebecryl 600 » par la résine « Ebecryl 860 » de même provenance (époxy acrylate de l'huile de soja de poids moléculaire de l'ordre de 1 200). On enduit le support dans les mêmes conditions que celles décrites dans

4

l'exemple 1.

Après insolation, on constate que la plaque n'est pas développable avec le même révélateur que dans l'exemple 1.

Exemple comparatif B

L'exemple 1 est reproduit, mais en mettant en œuvre 3,5 g de résine époxy et 0,5 g de triacrylate soit un rapport pondéral de 7/1 : après une insolation de 5 secondes seulement, 4 à 6 plages de la gamme de Stauffer sont couvertes ; pour couvrir de 7 à 8 plages de cette gamme, le temps d'insolation devrait approcher 20 secondes.

Exemple 2

On prépare la solution suivante :

| | | |
|---|---|---|
| — oligotriacrylate (appellation commerciale « OTA 480 » de la Société Union Chimique Belge) | 1 | g |
| — résine époxyacrylate « Ebecryl 600 » | 3 | g |
| — méthylcellosolve | 150 | g |
| — n-butanol | 20 | g |
| — « Irgacure 651 » | 0,6 | g |
| — cétone de Michler | 0,3 | g |
| — éther monométhylique de l'hydroquinone | 0,03 | g |

On applique cette couche sur le support décrit dans l'exemple 1 et dans les mêmes conditions. Après exposition de la plaque à travers un négatif pendant 5 à 6 secondes, on développe celle-ci comme dans l'exemple 1.

On obtient une excellente copie avec 6 à 7 plages couvertes de la gamme Stauffer.

Exemple 3

On prépare la solution selon la formule suivante :

| | | |
|---|---|---|
| — acrylate de bis-pentaerythritol | 1 | g |
| — « Ebecryl 600 » | 3 | g |
| — méthylcellosolve | 150 | g |
| — n-butanol | 20 | g |
| — « Irgacure 651 » | 0,6 | g |
| — cétone de Michler | 0,3 | g |
| — éther monométhylique de l'hydroquinone | 0,03 | g |

On procède de la même manière que dans l'exemple 1. Après développement, on obtient une plaque d'excellente qualité avec 5 à 6 plages couvertes de la gamme Stauffer.

Exemple 4

On prépare une solution photosensible selon la formule suivante :

| | | |
|---|---|---|
| — triacrylate de pentaerythritol | 1 | g |
| — résine époxyacrylate commercialisée sous l'appellation « Epocryl 370 », par la Société Shell Chemical Corp. | 3 | g |
| — méthylcellosolve | 140 | g |
| — n-butanol | 20 | g |
| — « Irgacure 651 » | 0,6 | g |
| — cétone de Michler | 0,3 | g |
| — éther monométhylique de l'hydroquinone | 0,03 | g |

On enduit cette couche sur le support décrit dans l'exemple 1 et dans les mêmes conditions. On applique une surcouche de protection avec une solution d'alcool polyvinylique à 3 % selon la technique habituelle. La plaque ainsi obtenue est exposée à travers un montage négatif sous une lampe à arc du type NU ARC 2 KW, pendant 2 à 3 sec.

On obtient une excellente copie avec 8 à 9 plages couvertes de la gamme Stauffer.

Pour obtenir le même résultat avec les plaques habituellement utilisées dans l'imprimerie, il faudrait un temps d'insolation 50 fois plus long.

La plaque supporte très bien un vieillissement accéléré dans l'étuve à 60 °C pendant 48 heures, s'encre très bien et ne graisse pas.

Exemple 5

On prépare dans les mêmes conditions que dans l'exemple 1 une solution photosensible, en remplaçant la cétone de Michler par l'éther éthylique de benzoïne. Après exposition à travers un négatif pendant 5 à 6 sec., on obtient une excellente copie, avec 6 à 7 plages couvertes de la gamme Stauffer.

## Exemple 6

On prépare une solution photosensible selon la formule suivante :

| | | |
|---|---:|---|
| — triacrylate de pentaerythritol | 1 | g |
| — résine époxyacrylate « Epocryl 370 », | 3 | g |
| — méthylcellosolve | 140 | g |
| — n-butanol | 30 | g |
| — « Irgacure 651 » | 0,6. | g |
| — cétone de Michler | 0,3 | g |
| — éther monométhylique de l'hydroquinone | 0,03 | g |
| — Rouge feu Zapon, colorant commercialisé par la Société Basf | 0,06 | g |

On procède comme dans l'exemple 4.

Après exposition à travers un montage négatif pendant 7 à 8 sec., on obtient une excellente copie avec 6 à 7 plages couvertes de la gamme Stauffer.

## Exemple 7

On prépare dans les mêmes conditions que celles de l'exemple 4, une solution photosensible à 3 % de solide.

On enduit cette solution à l'aide d'une tournette à 50 t/mn pendant 30 sec. sur une plaque d'acier cuivrée, chromée, traitée d'abord avec une solution de « Ludox » commercialisée par la Société Seppic, à 2 % dans l'eau puis avec une solution de polyacrylamide à 0,5 % dans l'eau.

Une couche protectrice d'alcool polyvinylique à 3 % dans l'eau est appliquée selon la technique habituelle.

Après exposition de la plaque à la lumière actinique pendant 2 sec. à travers un film négatif, on développe celle-ci avec le révélateur QM 805.

On obtient une excellente copie avec 8 plaques couvertes de la gamme Stauffer.

## Exemple 8

On prépare dans les mêmes conditions que celles de l'exemple 7 la couche photosensible en ajoutant 0,12 g du colorant rouge feu Zapon.

On applique cette couche sur le même support et dans les mêmes conditions que celles de l'exemple 7. Après insolation à travers un négatif pendant 25 sec., on obtient une excellente copie avec 7 plages couvertes de la gamme Stauffer.

**Revendications** (pour les Etats contractants : BE, CH, DE, FR, GB, IT, LI, LU, NL, SE)

1. Compositions photosensibles destinées en particulier à la préparation de plaques lithographiques et comprenant une résine époxy acrylate liquide ou visqueuse, un monomère pris dans le groupe formé par les acrylates ou méthacrylates de polyols ou d'oligomères hydroxylés et au moins un photoinitiateur caractérisé en ce que la résine époxyde dont la viscosité à 60 °C est comprise entre 4 et 8 Pa.s et dont le poids moléculaire est compris entre 400 et 1 000 présente deux liaisons oléfiniques terminales et appartient aux résines époxy-phénol-novolaques ou aux résines époxy contenant du bisphénol A ou F et où, au moins deux groupes époxydes par mole de résine finale sont en quasi-totalité ouverts et estérifiés, et en ce que la résine époxy acrylate et le monomère acrylique se trouvent dans un rapport pondéral compris entre 5 : 1 et 2 : 1.

2. Composition photosensible selon la revendication 1, caractérisée en ce que la résine époxy acrylate a un poids moléculaire compris entre 400 et 600.

3. Composition photosensible selon la revendication 1, caractérisée en ce qu'elle contient un mélange de photosensibilisateur constitué d'une part par le benzyl-diméthylacétal et d'autre part, par la cétone de Michler ou un éther de la benzoïne.

4. Composition photosensible selon l'une quelconque des revendications précédentes, caractérisée en ce que la proportion pondérale de photosensibilisateur par rapport à la résine, est compris entre 15 et 35 %.

5. Composition photosensible selon l'une quelconque des revendications précédentes, caractérisée en ce qu'elle contient en outre, un inhibiteur de polymérisation radicalaire thermique en une proportion pondérale par rapport à la résine, comprise entre 0,5 et 1,5 %.

6. Plaque lithographique comprenant un support métallique grainé pris dans le groupe constitué par l'aluminium éventuellement oxydé en surface et l'acier cuivré puis chromé, caractérisée en ce que ledit support est revêtu d'une composition photosensible selon l'une quelconque des revendications précédentes.

7. Plaque lithographique selon la revendication 6, caractérisée en ce qu'une sous-couche constituée par le produit résultant d'un traitement à l'aide d'un silicate ou d'un sel de silice, est présent sous la composition photosensible.

8. Plaque lithographique selon la revendication 7, caractérisée en ce que cette sous-couche comprend également le produit résultant d'un traitement par un polyacrylamide.

9. Plaque lithographique selon l'une des revendications 6 à 8, caractérisée en ce qu'elle comprend une couche superficielle d'alcool polyvinylique.


**Revendications** (pour l'Etat contractant AT)

1. Procédé de préparation d'une plaque lithographique consistant à déposer sur une plaque métallique une couche photosensible d'épaisseur comprise entre 0,5 et 2 micromètres et constituée d'une composition photosensible diluée dans un solvant polaire relativement volatil et puis à sécher la plaque, la composition comprenant une résine époxy acrylate liquide ou visqueuse, un monomère pris dans le groupe formé par les acrylates ou méthacrylates de polyols ou d'oligomères hydroxylés et au moins un photoinitiateur caractérisé en ce que la résine époxyde dont la viscosité à 60 °C est comprise entre 4 et 8 Pa.s et dont le poids moléculaire est compris entre 400 et 1 000 présente deux liaisons oléfiniques terminales et appartient aux résines époxy-phénol-novolaques ou aux résines époxy contenant du bisphénol A ou F et où, au moins deux groupes époxydes par mole de résine finale sont en quasi-totalité ouverts et estérifiés, et en ce que la résine époxy acrylate et le monomère acrylique se trouvent dans un rapport pondéral compris entre 5 : 1 et 2 : 1.

2. Procédé selon la revendication 1, caractérisé en ce que la résine époxy acrylate a un poids moléculaire compris entre 400 et 600.

3. Procédé selon la revendication 1, caractérisé en ce qu'elle contient un mélange de photosensibilisateur constitué d'une part par le benzyl-diméthylacétal et d'autre part, par la cétone de Michler ou un éther de la benzoïne.

4. Procédé selon l'une quelconque des revendications précédentes, caractérisé en ce que la proportion pondérale de photosensibilisateur par rapport à la résine, est compris entre 15 et 35 %.

5. Procédé selon l'une quelconque des revendications précédentes, caractérisé en ce qu'elle contient en outre, un inhibiteur de polymérisation radicalaire thermique en une proportion pondérale par rapport à la résine, comprise entre 0,5 et 1,5 %.

6. Utilisation des plaques obtenues selon les procédés des revendications 1 à 5 pour l'impression lithographique.


**Claims** (for the Contracting States : BE, CH, DE, FR, GB, IT, LI, LU, NL, SE)

1. Photosensitive compositions intended in particular for the preparation of lithographic plates and comprising a liquid or viscous epoxyacrylate resin, a monomer taken from the group consisting of acrylates or methacrylates of polyols or of hydroxylated oligomers and at least one photoinitiator, characterized in that the epoxide resin, whose viscosity at 60 °C is between 4 and 8 Pa s and whose molecular weight is between 400 and 1 000, contains two terminal olefinic bonds and belongs to epoxy-phenol-novolac resins or to epoxy resins containing bisphenol A or F and where at least two epoxide groups per mole of final resin are virtually completely open and esterified, and in that the epoxyacrylate resin and the acrylic monomer are in a weight ratio of between 5 : 1 and 2 : 1.

2. Photosensitive composition according to Claim 1, characterized in that the epoxyacrylate resin has a molecular weight of between 400 and 600.

3. Photosensitive composition according to Claim 1, characterized in that it contains a mixture of photosensitizer consisting, on the one hand, of benzyldimethylacetal and, on the other hand, of Michler's ketone or a benzoin ether.

4. Photosensitive composition according to any one of the preceding claims, characterized in that the weight proportion of photosensitizer is between 15 and 35 %, based on the resin.

5. Photosensitive composition according to any one of the preceding claims, characterized in that it additionally contains an inhibitor of thermal radical polymerization in a weight proportion of between 0.5 and 1.5 %, based on the resin.

6. Lithographic plate comprising a grained metal support taken from the group consisting of aluminium whose surface is optionally oxidized and steel which is copperplated and then chromium-plated, characterized in that the said support is coated with a photosensitive composition according to any one of the preceding claims.

7. Lithographic plate according to Claim 6, characterized in that an undercoat consisting of the

7

product resulting from a treatment using a silicate or a silica salt is present under the photosensitive composition.

8. Lithographic plate according to Claim 7, characterized in that this undercoat also comprises the product resulting from a treatment with a polyacrylamide.

9. Lithographic plate according to one of Claims 6 to 8, characterized in that it comprises a surface coat of polyvinyl alcohol.


**Claims** (for the Contracting State AT)

1. Process for the preparation of a lithographic plate consisting in depositing on a metal plate a photosensitive layer with a thickness of between 0.5 and 2 micrometres and consisting of a photosensitive composition diluted in a relatively volatile polar solvent and then drying the plate, the composition comprising a liquid or viscous epoxyacrylate resin, a monomer taken from the group consisting of acrylates or methacrylates of polyols or hydroxylated oligomers and at least one photoinitiator characterized in that the epoxide resin, whose viscosity at 60 °C is between 4 and 8 Pa.s and whose molecular weight is between 400 and 1 000, has two terminal olefinic bonds and belongs to epoxy-phenol-novolac resins or to epoxy resins containing bisphenol A or F and where at least two epoxide groups per mole of final resin are virtually completely open and esterified, and in that the epoxyacrylate resin and the acrylic monomer are in a weight ratio of between 5 : 1 and 2 : 1.

2. Process according to Claim 1, characterized in that the epoxyacrylate resin has a molecular weight of between 400 and 600.

3. Process according to Claim 1, characterized in that it contains a mixture of photosensitizer consisting, on the one hand, of benzyldimethylacetal and, on the other hand, of Michler's ketone or a benzoin ether.

4. Process according to any one of the preceding claims, characterized in that the weight proportion of photosensitizer is between 15 and 35 %, based on the resin.

5. Process according to any one of the preceding claims, characterized in that it additionally contains an inhibitor of thermal radical polymerization in a weight proportion of between 0.5 and 1.5 %, based on the resin.

6. Use of the plates produced according to the processes of Claims 1 to 5 for lithographic printing.


**Patentansprüche** (für die Vertragsstaaten : BE, CH, DE, FR, GB, IT, Li, LU, NL, SE)

1. Photoempfindliche Massen, die insbesondere für die Herstellung von lithographischen Platten bestimmt sind und ein flüssiges oder viskoses Epoxy-Acrylatharz, ein Monomer aus der Gruppe ·der Acrylate oder Methacrylate von Polyolen oder hydroxylierten Oligomeren und mindestens einen Photoinitiator umfaßt, dadurch gekennzeichnet, daß das Epoxidharz, dessen Viskosität bei 60 °C 4 bis 8 Pa.s und dessen Molekulargewicht 400 bis 1 000 beträgt, zwei endständige olefinische Bindungen aufweist und zu den Epoxy-Phenol-Novolakharzen oder zu den Epoxyharzen gehört, die Bisphenol A oder F enthalten und bei denen mindestens zwei Epoxygruppen je mol Harz-Endprodukt praktisch vollständig geöffnet und verestert sind, und daß das Epoxy-Acrylatharz und das Acrylmonomer in einem Gewichtsverhältnis von 5 : 1 bis 2 : 1 vorliegen.

2. Photoempfindliche Masse nach Anspruch 1, dadurch gekennzeichnet, daß das Epoxy-Acrylatharz ein Molekulargewicht von 400 bis 600 aufweist.

3. Photoempfindliche Masse nach Anspruch 1, dadurch gekennzeichnet, daß sie ein Photosensibilisator-Gemisch enthält, das zum einen aus Benzyl-dimethylacetal und zum anderen aus Michler-Keton oder einem Benzoin-ether besteht.

4. Photoempfindliche Masse nach einem der vorangehenden Ansprüche, dadurch gekennzeichnet, daß der Gewichtsanteil an Photosensibilisator, bezogen auf das Harz, 15 bis 35 % ausmacht.

5. Photoempfindliche Masse nach einem der vorangehenden Ansprüche, dadurch gekennzeichnet, daß sie zusätzlich einen Inhibitor für die thermisch-radikalische Polymerisation in einem Gewichtsanteil, bezogen auf das Harz, von 0,5 bis 1,5 % enthält.

6. Lithographische Platte, umfassend einen gekörnten metallischen Träger aus der Gruppe Aluminium, das gegebenenfalls an der Oberfläche oxidiert ist sowie mit Kupfer und dann mit Chrom behandeltem Stahl, dadurch gekennzeichnet, daß der Träger mit einer photoempfindlichen Masse nach einem der vorangehenden Ansprüche beschichtet ist.

7. Lithographische Platte nach Anspruch 6, dadurch gekennzeichnet, daß unter der photoempfindlichen Masse eine Unterschicht vorhanden ist, die aus dem Produkt, das bei der Behandlung mit Hilfe eines Silicats oder eines Kieselsäuresalzes erhalten wird, besteht.

8. Lithographische Platte nach Anspruch 7, dadurch gekennzeichnet, daß die Unterschicht auch das Produkt der Behandlung mit einem Polyacrylamid umfaßt.

9. Lithographische Platte nach einem der Ansprüche 6 bis 8, dadurch gekennzeichnet, daß sie eine Oberflächenschicht aus Polyvinylalkohol umfaßt.

**Patentansprüche** (für den Vertragsstaat AT)

1. Verfahren zur Herstellung einer lithographischen Platte, bei dem auf eine Metallplatte eine 0,5 bis 2 µm starke photoemfindliche Schicht aus einer photoempfindlichen Masse, verdünnt in einem relativ flüchtigen Lösungsmittel, aufgetragen und die Platte dann getrocknet wird, wobei die Masse ein flüssiges oder viskoses Epoxy-Acrylatharz, ein Monomer aus der Gruppe der Acrylate oder Methacrylate von Polyolen oder hydroxylierten Oligomeren und mindestens einen Photoinitiator umfaßt, dadurch gekennzeichnet, daß das Epoxidharz, dessen Viskosität bei 60 °C 4 bis 8 Pa.s und dessen Molekulargewicht 400 bis 1 000 beträgt, zwei endständige olefinische Bindungen aufweist und zu den Epoxy-Phenol-Novolakharzen oder zu den Epoxyharzen gehört, die Bisphenol A oder F enthalten und bei denen mindestens zwei Epoxygruppen je mol Harz-Endprodukt praktisch vollständig geöffnet und verestert sind, und daß das Epoxy-Acrylatharz und das Acrylmonomer in einem Gewichtsverhältnis von 5 : 1 bis 2 : 1 vorliegen.

2. Verfahren nach Anspruch 1, dadurch gekennzeichnet, daß das Epoxy-Acrylatharz ein Molekulargewicht von 400 bis 600 aufweist.

3. Verfahren nach Anspruch 1, dadurch gekennzeichnet, daß die Masse ein Photosensibilisator-Gemisch enthält, das zum einen aus Benzyl-dimethylacetal und zum anderen aus Michler-Keton oder einem Benzoin-ether besteht.

4. Verfahren nach einem der vorangehenden Ansprüche, dadurch gekennzeichnet, daß der Gewichtsanteil an Photosensibilisator, bezogen auf das Harz, 15 bis 35 % ausmacht.

5. Verfahren nach einem der vorangehenden Ansprüche, dadurch gekennzeichnet, daß sie zusätzlich einen Inhibitor für die thermisch-radikalische Polymerisation in einem Gewichtsanteil, bezogen auf das Harz, von 0,5 bis 1,5 % enthält.

6. Verwendung der nach den Verfahren der Ansprüche 1 bis 5 erhaltenen Platten für den lithographischen Druck.